Europäisches Patentamt

European Patent Office

Office européen des brevets

(19)

(11) Veröffentlichungsnummer: **0 205 028 B1**

(12) **EUROPÄISCHE PATENTSCHRIFT**

(45) Veröffentlichungstag der Patentschrift: **18.09.91**

(51) Int. Cl.5: **C23C 14/38**, H01L 21/203, H01L 21/363

(21) Anmeldenummer: **86107149.6**

(22) Anmeldetag: **27.05.86**

(54) Vorrichtung zum Aufbringen dünner Schichten auf ein Substrat.

(30) Priorität: **12.06.85 DE 3521053**

(43) Veröffentlichungstag der Anmeldung:
**17.12.86 Patentblatt 86/51**

(45) Bekanntmachung des Hinweises auf die
Patenterteilung:
**18.09.91 Patentblatt 91/38**

(84) Benannte Vertragsstaaten:
**AT BE CH DE FR GB IT LI LU NL SE**

(56) Entgegenhaltungen:
EP-A- 0 121 625          DD-A- 138 679
DD-A- 142 568           DE-A- 3 331 707
US-A- 4 094 764         US-A- 4 187 124
US-A- 4 278 528         US-A- 4 514 437

(73) Patentinhaber: **LEYBOLD AKTIENGESELL-
SCHAFT**
**Wilhelm-Rohn-Strasse 25**
**W-6450 Hanau am Main 1(DE)**

(72) Erfinder: **Dietrich, Anton, Dr. Dipl.-Phys.**
**Unterfeld 606 B**
**FL-9495 Triesenlden(LI)**
Erfinder: **Hartig, Klaus, Dr. Dipl.-Phys.**
**Hanauer Strasse 17**
**W-6451 Ronneburg - 2(DE)**

(74) Vertreter: **Schickedanz, Willi, Dipl.-Ing.**
**Langener Strasse 68**
**W-6050 Offenbach/Main(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Rank Xerox (UK) Business Services

**Beschreibung**

Die Erfindung betrifft eine Vorrichtung zum Aufbringen dünner Schichten auf ein Substrat mittels des Katodenzerstäubungsverfahrens.

Auf zahlreichen Gebieten der Technik ist es erforderlich, sehr dünne Schichten von reinen Stoffen auf bestimmten Gegenständen anzubringen. Beispiele hierfür sind etwa Fenster-Gläser, die mit einer dünnen Metall- oder Metalloxid-Schicht versehen werden, um aus dem Sonnenlicht bestimmte Wellenlängenbereiche auszublenden. Auch in der Halbleitertechnik werden oft auf einem ersten Substrat dünne Schichten eines zweiten Substrats aufgebracht. Besonders wichtig ist hierbei, daß die dünnen Schichten nicht nur sehr rein sind, sondern auch sehr genau dosiert werden müssen, damit die jeweiligen Schichtdicken - und im Fall von Schichten aus chemischen Verbindungen deren Zusammensetzung - exakt reproduzierbar sind. Diese Schichtdicken liegen in der Regel zwischen 2 und einigen tausend Nanometern.

Um dünne Schichten auf Folien, Gläsern und anderen Substraten aufzubringen, sind im wesentlichen drei verschiedene Verfahren bekannt. Bei dem ersten Verfahren wird die dünne Schicht durch chemische oder elektrochemische Abscheidung aufgebracht, während bei dem zweiten Verfahren die Schicht durch Verdampfen im Vakuum aufgebracht wird.

Diese beiden Verfahren gestatten es jedoch nicht, große Flächen mit der gleichmäßig erforderlichen Genauigkeit und Reproduzierbarkeit mit sehr dünnen Schichten zu versehen, weshalb immer häufiger das dritte Verfahren, das sogenannte "Sputtern" oder Katodenzerstäuben herangezogen wird.

Bei diesem Katodenzerstäubungs-Verfahren sind ein Gasentladungsplasma, eine zu zerstäubende Substanz an einer Katode - die auch Target genannt wird - und ein zu beschichtendes Substrat in einer Vakuum-Kammer vorgesehen.

Durch die Ionen eines Glimmentladungsplasmas, die auf das zu zerstäubende Katoden-Substrat aufprallen, lösen sich Atome vom Target und lagern sich auf dem zu beschichtenden Substrat ab. Die Glimmentladung wird dabei durch ein elektrisches Feld bewirkt, das durch eine Spannung von etwa hundert Volt zwischen Anode und Katode erzeugt wird, wobei die Anode in vielen Fällen durch die metallische Wand eines Vakuumbehälters gebildet wird. Da die Katode durch die mit großer Energie aufprallenden Ionen wirksam zerstäubt, wird Material der Katode in atomarer Form abgetragen, welches als Gas von der Katode fortdiffundiert, um sich an festen Flächen in Katodennähe in Form fest haftender Überzüge niederzuschlagen, deren Dicke mit der Betäubungszeit proportional zunimmt.

Es hat sich gezeigt, daß reine Metalle oder dotierte, elektrisch leitende Halbleiter wesentlich besser als Katodenzerstäubungsmaterial geeignet sind als z. B. ihre Oxide. So läßt sich beispielsweise eine aus Siliziumdioxid bestehende Katode nur mit Hochfrequenz und auch dann nur in geringen Raten zerstäuben, während das Zerstäuben von dotiertem Silizium auch bei Gleichspannung mit hohen Raten möglich ist. Das Aufbringen von dielektrischen Schichten mittels der Hochfrequenzzerstäubung der entsprechenden Materialien ist außerdem wegen des technischen Aufwands nur für Substratflächen wirtschaftlich, die kleiner als 1 m² sind. Sollen dünne Schichten Von Metalloxiden auf ein Substrat aufgebracht werden, so werden zunächst die Metallatome mittels des Katodenzerstäubungsverfahrens aus der Metallkatode herausgeschlagen. Sodann werden diese Atome oxidiert und auf dem Substrat niedergeschlagen. Zur Durchführung eines solchen Verfahrens werden zwei verschiedene Gase benötigt: ein erstes, reaktionsunfähiges Gas, z. B. Argon, das für die Erzeugung des Glimmentladungsplasmas erforderlich ist und ein zweites, reaktionsfähiges Gas, z. B. Sauerstoff, das mit den Metall- oder Halbleiteratomen ein Oxid bildet.

Es ist bereits ein Verfahren zum Herstellen einer schweroxidierbaren Schicht auf einem Körper aus einem leichtoxidierbaren Metall oder einer entsprechenden Metallegierung bekannt, bei dem der leicht oxidierte Körper durch Tempern unter Vakuum von seiner Oxidhaut weitgehend befreit und dann ohne Unterbrechung im Vakuum mit einer schweroxidierbaren Schutzschicht versehen wird (DE-AS 26 16 270). Nachteilig ist bei diesem Verfahren, daß vor dem Aufstäuben des schweroxidierbaren Materials ein aufwendiger Ätzvorgang durchgeführt werden muß.

Weiterhin ist eine Einrichtung zum reaktiven Beschichten mit dem Plasmatron bekannt, welche vorzugsweise zum Aufstäuben von Schichten aus chemischen Verbindungen wie Oxiden oder Karbiden zur Anwendung kommt (DD-PS 142 568). Um den Reaktionsgrad und die Kondensationsrate bei dieser Einrichtung zu erhöhen, wird die Umgebung der Katode auf leicht negatives Potential gelegt, wobei die bei der Entladung anfallenden langsamen Elektronen auf das geerdete und damit positive Substrat gelenkt werden. Dieses Verfahren ist jedoch dann nicht anwendbar, wenn die Substrate nicht leitfähig sind. Außerdem überzieht sich die Hilfselektrode nach kurzer Zeit mit einer nichtleitfähigen Schicht, was die Wirkung beeinträchtigt.

Es ist außerdem eine Vorrichtung zum reaktiven Aufstäuben von Verbindungen von Metallen und Halbleitern bekannt, bei der in einem Raum, der sich zwischen einer Magnetron-Katode mit einem Target und einem Substrat befindet, getrennt ein Edelgas und ein Reaktionsgas für die Bildung der gewünschten Verbindung mit dem Targetmaterial eingeleitet wird (DE-A-33 31 707). Hierbei wird, um den Zerstäubungsprozeß langzeitig stabil aufrechterhalten zu können, zwischen dem Target und dem Substrat durch eine Blende eine Strömungsverengung herbeigeführt. Mit dieser bekannten Vorrichtung ist es möglich, sehr präzise und gleichmäßig auch großflächig dünne Schichten auf Folien und dergleichen aufzubringen. Ferner werden die Edelgase zwischen Target und Blende an der Peripherie des Targets zugeführt. Weiterhin wird das Reaktionsgas dem Stoffstrom durch eine jenseits der Blende liegende Verteileinrichtung zugeführt, und schließlich wird eine Glimmentladung auch im Bereich zwischen Blende und Substrat durch eine jenseits der Blende angeordnete, dem Reaktionsgas ausgesetzte Anode aufrechterhalten. Es ist jedoch bei dieser Vorrichtung notwendig, insbesondere bei sehr reaktionsfreudigen Targetmaterialien, mittels der Funktionsblende eine sehr starke Strömungsverengung zwischen Target und Substrat herbeizuführen, um das reaktive Gas von der Katode fernzuhalten, wodurch ein großer Teil der herausgeschlagenen Targetatome nicht zum Substrat gelangt und dadurch nicht zum Aufwachsen der Schicht auf dem Substrat beiträgt. Bei einer größeren Blendenöffnung sammeln sich auf der Katode Oxide an, die sich aufgrund einer Verbindung der herausgeschlagenen Targetatome mit den Atomen des Reaktionsgases gebildet haben. Durch die Ablagerung dieser Oxide auf dem Target wird das Herausschlagen weiterer Atome durch die Ionen des inerten Gases erschwert, so daß sich allmählich der Beschichtungsprozeß verschlechtert. Außerdem neigt die bekannte Vorrichtung zur Überhitzung, und die isoliert aufgehängte Anode überzieht sich mit Isoliermaterial.

Es ist ferner eine Anordnung mit einer Atom- bzw. Molekularstrahlenquelle bekannt, die zur Beschichtung eines Substrats nach dem Prinzip der Zerstäubung fester Materialien durch Ionenbeschuß dient (DD-PS 138 679). Hierbei wird ein Target bei höherem Entladungsdruck in einer vom Substratraum getrennten Kammer zerstäubt, wobei die Öffnung zwischen Target und Substratraum als Druckstufe wirkt. Für das reaktive Zerstäuben ist diese Anordnung jedoch nicht geeignet, weil hierfür am Target eine Reaktion mit dem Reaktivgas verhindert werden muß, was am Target einen niedrigeren und nicht einen höheren Partialdruck erfordert.

Weiterhin ist ein Festkörper-Bauelement vom Schottky-Barrier-Typ sowie ein Verfahren zu seiner Herstellung bekannt (US-A-4 218 495). Hierbei wird eine Metallschicht mit einer Halbleiterschicht versehen, wobei die Metallschicht aus einem solchen Metall besteht, daß eine Schottky-Barrier zwischen dieser Metallschicht und der Halbleiterschicht aufgebaut werden kann. Eine Anschlußelektrode auf der Halbleiterseite, die mit der äußeren Oberfläche des Halbleiter-Films verbunden ist, wird so angeschlossen, daß sie einen ohmschen Kontakt herstellt.

Mindestens die Halbleiterschicht wird mittels eines sogenannten Strahl-Niederschlag-Verfahrens mit ionisierten Haufen (ionized-cluster beam deposition process) aufgebracht. Bei diesem Verfahren handelt es sich um eine spezielle Form des Aufdampfens mit einer Kondensation eines Dampfstrahls zu Tröpfchen, die dann gezielt beschleunigt werden und so die Einstellung der Wachstumsform der Schicht erlauben.

Für das reaktive Zerstäuben ist dieses Verfahren jedoch nicht geeignet, da weder Glimmentladungen auftreten, noch Gemische aus reaktionsfähigen und nichtreaktionsfähigen Gasen zugeführt werden.

Es ist ferner ein Verfahren für die Herstellung von Lumineszenz-Glasschichten bekannt, das mit Katoden-Zerstäubung arbeitet, wobei das Target Silizium und mindestens eine chemische Verbindung enthält, die Lumineszenz-Zentren bereitstellt, z. B. Zeroxid.

Zwischen dem Target und einem Träger wird ein Plasma mit $A^+$ - Ionen aufgebaut, und zwar zwischen zwei Abschirmungen. Es ist also nur ein einziges Plasma vorgesehen.

Schließlich ist auch noch eine Einrichtung für die Katoden-Zerstäubung mit hoher Niederschlagsrate bekannt, bei welcher der Niederschlag auf einem Substrat aufgebracht wird, das sich innerhalb eines gepumpten Gehäuses befindet und bei welcher das Target auf negativem Potential bezüglich einer Anode liegt (US-A-4 094 764). Hierbei wird ein Gas unter einem Druck P in den Raum zwischen Target und Anode gebracht. Es entsteht zwischen dem Target und dem Substrat ein hoher Gasdruckgradient. Außerdem wird ein Magnetfeld in einer Richtung parallel zur Targetoberfläche erzeugt, die dem Target gegenüberliegt, wobei eine Abschirmung um das Target herum vorgesehen ist. Die hohe Niederschlagsrate ergibt sich u. a. daraus, daß der Druck des Gases in der unmittelbaren Nachbarschaft des Targets sehr hoch, in der Nähe des Substrats jedoch gering ist, wodurch das Plasma eine geringe Absorptionskapazität für die zerstäubten Teilchen besitzt. Eine Erniedrigung eines Reaktivgasanteils unmittelbar vor dem Target zur Erhöhung der Rate ist mit dieser Einrichtung jedoch nicht möglich. Anders als die Vorrichtung gemäß DE-A-33 31 707 besitzt diese Einrichtung auch keine Blende zwischen Target und Anode.

Der Erfindung liegt deshalb die Aufgabe zugrunde, den Katodenzerstäubungsprozeß in der Weise zu verbessern, daß über längere Zeiträume exakte Beschichtungen mit höherem Ausnutzungsgrad des Targetmaterials möglich ist.

Diese Aufgabe wird bei einer Vorrichtung zum Aufbringen dünner Schichten auf einem Substrat durch das Kathodenzerstäubungsverfahren mit den im Anspruch 1 angegebenen Merkmalen gelöst.

Der mit der Erfindung erzielte Vorteil besteht insbesondere darin, daß eine getrennte Zufuhr von zwei verschiedenen Gasen, dem Reaktionsgas und dem inerten Gas, nicht erforderlich ist und trotzdem ein außerordentlich gutes Auftragen dünner Schichten möglich ist. Während bei der bekannten Vorrichtung Drücke in der Größenordnung von 1-2 Pa (1 -2 x $10^{-2}$ mB) herrschen, liegen bei der erfindungsgemäßen Vorrichtung Drücke von nur 0.2 Pa (2 x $10^{-3}$ mBar) vor. Ein geringerer Druck bedeutet aber geringere Verschmutzung und damit reinere Aufdampfungssubstanzen. Außer der besseren Schichtqualität ergibt sich durch die Erfindung auch noch eine höhere Schichtwachstumsrate für dielektrische Schichten im Vergleich zu den bekannten Verfahren sowie eine bessere Kontrollierbarkeit der Zusammensetzung von Schichten, die durch eine chemische Reaktion des Targetmaterials mit einem eingelassenen Reaktivgas gebildet werden. In der bekannten Vorrichtung zum reaktiven Aufstäuben von Verbindungen ist in den meisten Fällen die chemische Reaktionsgeschwindigkeit der begrenzende Prozeß für die Schichtwachstumsrate. Durch die erfindungsgemäße Anordnung einer zusätzlichen Glimmentladung unmittelbar vor dem Substrat, die unabhängig von der Glimmentladung des Zerstäubungsprozesses vor der Katode in ihrer Intensität über das Potential an der Anodenvorrichtung gesteuert werden kann, wird eine wesentliche Verbesserung erreicht. Da das reaktionsfähige Gas in diesen Raum der Glimmentladung vor dem Substrat eingeleitet wird und die chemische Reaktionsfreudigkeit des Gases durch Ionisation in dieser Glimmentladung erhöht werden kann, wird die chemische Reaktionsgeschwindigkeit für die Bildung der Verbindung an der Substratoberfläche vergrößert und damit die Schichtwachstumsrate.

Weiterhin ist es in einigen Fällen notwendig, die Zusammensetzung oder Stöchiometrie der aufgestäubten Schichten sehr genau zu kontrollieren, um gewünschte Schichteigenschaften zu erreichen. Ein Beispiel dafür ist das Aufstäuben von transparenten, elektrisch leitenden Schichten aus Verbindungen von Indiumoxid und Zinnoxid. Bei diesen Schichten ist die elektrische Leitfähigkeit sehr empfindlich vom Sauerstoffgehalt dieser Schichten abhängig. Mit der erfindungsgemäßen Vorrichtung ist es möglich, über die Kontrolle der Glimmentladung vor dem Substrat die Zusammensetzung der Schicht in der erforderlichen Weise zu steuern, so daß auch auf Kunststoffolien mit bis zu 2m Breite Schichten dieser Verbindungen mit hoher Rate und guter Qualität aufgestäubt werden können.

Ein weiterer Vorteil der Erfindung besteht darin, daß sie nicht nur beim Aufstäuben von Verbindungen, sondern auch beim Aufstäuben von reinen metallischen Schichten auf bewegte Substrate eine Verbesserung im Vergleich zu bekannten Anordnungen mit sich bringt. Das zusätzliche Plasma an der Substratoberfläche führt zu einem intensiven Elektronen- und Ionenbeschuß eines bewegten Substrats unmittelbar bevor es in die Beschichtungszone gelangt. Dies führt zu einem Abtragen oder Zerstäuben von locker gebundenen Teilchen an der Substratoberfläche, die sonst die Haftung der aufgestäubten Schicht verschlechtern würde. Dies gilt insbesondere auch für den Fall, daß reine Metalle oder Halbleiterschichten aufgestäubt werden, also nur ein reaktionsfähiges Gas eingelassen wird.

Ein Ausführungsbeispiel der Erfindung ist in der Zeichnung dargestellt und wird im folgenden näher beschrieben. Es zeigen:

Fig. 1 eine Prinzipdarstellung der Erfindung, die eine Katodenzerstäubungsvorrichtung im Zusammenwirken mit einer über eine Trommel geführten und zu beschichtenden Folie veranschaulicht;

Fig. 2 eine Detaildarstellung einer tatsächlichen Realisierungsform der erfindungsgemäßen Katodenzerstäubungsvorrichtung;

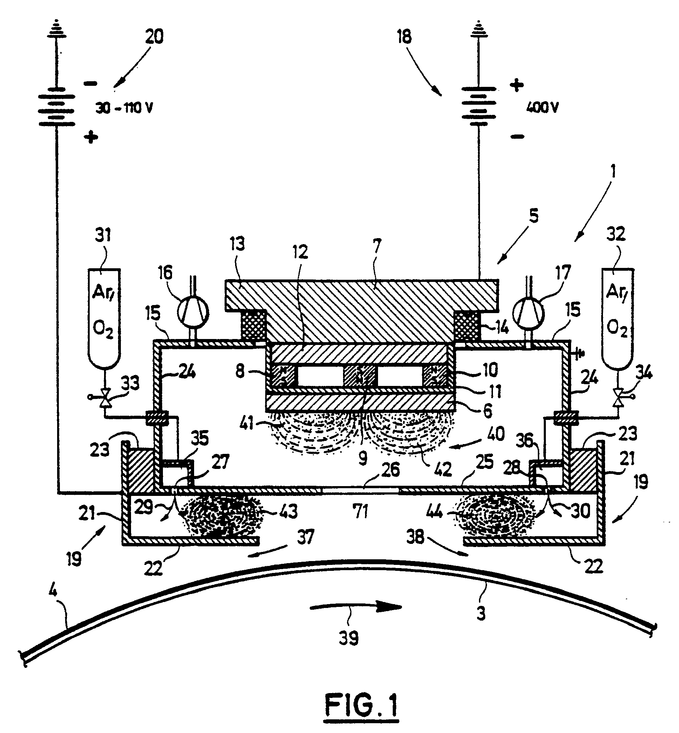

In der Fig. 1 ist eine Katodenzerstäubungsvorrichtung 1 gezeigt, die gegenüber einer Trommel angeordnet ist, auf deren Oberfläche 3 sich eine dünne Folie 4 befindet, die mit einem Oxid, beispielsweise $Al_2O_3$, beschichtet werden soll. Die Katodenzerstäubungsvorrichtung 1 weist eine Katodenvorrichtung 5 auf, die ihrerseits die eigentliche Zerstäubungskatode 6 und eine Katodenhalterung besitzt. Zwischen der Zerstäubungskatode 6, die z. B. aus reinem Aluminium besteht, und der Katodenhalterung 7 sind Permanentmagnete 8,9,10 vorgesehen, die auf einem Hohlkörper 11 ruhen und durch ein gemeinsames Joch 12 abgeschlossen sind. Der Rand des Hohlkörpers 11 ist gas- und flüssigkeitsdicht mit der Katodenhalterung 7 verbunden. Im Hohlkörper 11 wird eine Kühlflüssigkeit, z. B. Wasser, in direktem oder indirektem Kontakt an das Target 6 geführt. Auf der Vorderseite des Hohlkörpers 11 ist das Target bzw. die Zerstäubungskatode 6 angeordnet, die in elektrischer und gut wärmeleitender Verbindung zur Katodenhalterung 7 steht.

Die Katodenhalterung 7 besitzt einen flanschförmigen Rand 13, der unter Zwischenschaltung eines Isolators 14 mit der Decke 15 einer Katodenkammer 40 verbunden ist. Mit dieser Decke 15 sind auch eine oder mehrere Pumpen 16,17 über große Saugquerschnitte verbunden, die ständig die Katodenkammer 40 leerpumpen. Die Katodenhalterung 7 ist elektrisch mit dem negativen Pol einer Gleichspannungsquelle 18 verbunden, die eine Gleichspannung von etwa 400 Volt liefert. Der Katodenvorrichtung 5 ist eine Anodenvorrichtung 19 zugeordnet, die an dem positiven Pol einer Gleichspannungsquelle 20 liegt, die eine Gleichspannung von ca. 30 Volt bis 100 Volt liefert. Die Anodenvorrichtung 19 weist zwei senkrecht aufeinanderstehende Schenkel 21,22 auf, wobei der eine Schenkel 21 über einen Isolator 23 mit einer Seitenwand 24 der Katodenkammer verbunden ist.

Zwischen der Anodenvorrichtung 19 und der Katodenvorrichtung 5 ist eine Blende 25 mit einer zentralen Öffnung 26 angeordnet, die außerdem mindestens zwei seitliche Öffnungen 27,28 aufweist, durch die das Gas strömen kann, was durch einen Doppelpfeil 29,30 angedeutet ist. Das hierfür erforderliche Gas kommt aus Gasquellen 31,32 und wird über Regelventile 33,34 jeweils einer Vorkammer 35,36 zugeführt, die sich auf der Oberseite der Blende 25 befindet. Als Gas kommt beispielsweise ein Gasgemisch aus Argon und Sauerstoff in Frage.

Die Pumpen 16,17 stehen in der Praxis oft nicht nur mit dem Raum 40 in Verbindung, sondern mit der ganzen Umgebung der Vorrichtung, also auch über die Spalten 37,38 mit dem Raum 71. Die Spalten 37,38 werden aber hier so eng gehalten, wie es mechanisch und elektrisch möglich ist, d. h. der Öffnungsquerschnitt beträgt maximal etwa 20 % des Öffnungsquerschnitts am Raum 40 zu den Pumpen, um den Gasfluß zu den Pumpen über die Spalten 37,38 klein zu halten. Damit wird das eingelassene reaktionsfähige Gemisch, das durch die Gasentladung 43,44 zusätzlich aktiviert wird, vor dem Substrat 4 konzentriert, um die Bildung der gewünschten chemischen Verbindung des Targetmaterials mit dem Reaktionsgas auf dem Substrat zu beschleunigen. Im Gegensatz dazu wird der Katodenraum 40 über große Öffnungsquerschnitte mit den Pumpen 16,17 verbunden, um die reaktiven Bestandteile des über die Öffnung 71 in den Raum 40 einströmenden Gases möglichst schnell wegzupumpen. Dies dient dazu, die Bildung einer chemischen Verbindung des reaktiven Gases mit der Targetoberfläche 6 zu unterbinden, insbesondere für den Fall, daß diese Verbindung elektrisch nichtleitend ist und damit den Gleichspannungszerstäubungsprozeß nach kurzer Zeit zum Erliegen bringen würde. Dies ist auch ein signifikanter Unterschied zu den bisher bekannten Vorrichtungen (z. B. US-A-4 204 942, US-A-4 298 444), da dort das eingelassene und nicht das durch das Schichtwachstum verbrauchte Gasgemisch ausschließlich über Spalten abgesaugt werden kann, die durch das Substrat und durch eine dem Substrat unmittelbar gegenüberliegende mechanische Blende analog zu den Spalten 37,38 der vorliegenden Vorrichtung gebildet werden.

Eine Mehrfachbeschichtung ist mit der Erfindung ebenfalls möglich, wobei jedoch, da die Spalten 37,38 breiter als in den Vorrichtungen gemäß US-PSen 4 204 942, 4 298 444 sind, Abdeckbleche zwischen den einzelnen Vorrichtungen, die um die Trommel 3 herum angeordnet sind, vorgesehen sind. Die relative Bewegungsrichtung der Trommel ist durch einen Pfeil 39 angedeutet; sie kann jedoch auch in entgegengesetzter Richtung verlaufen.

Wird das Gas eingelassen und die elektrische Gleichspannung an die Katodenvorrichtung 5 bzw. an die Anodenvorrichtung 19 gelegt, so bilden sich zwei Plasmazonen 40,71 aus, von denen in der Fig. 1 jeweils zwei Bereiche 41,42 bzw. 43,44 erkennbar sind.

Das zusätzliche Plasma 43,44 an der Substratoberfläche führt zu einem intensiven Elektronen- und Ionenbeschluß eines bewegten Substrats unmittelbar bevor es in die Beschichtungszone gelangt. Dies führt zu einem Abtragen bzw. Zerstäuben von locker gebundenen Teilchen an der Substratoberfläche, die sonst die Haftung der aufgestäubten Schicht verschlechtern würde. Dies gilt insbesondere auch für den Fall, daß reine Metall- oder Halbleiterschichten aufgestäubt werden, also nur reaktionsfähiges Gas eingelassen wird.

Die an sich bekannte Anordnung der Dauermagnete 8,9,10 ist für das Prinzip der Erfindung nicht von Bedeutung, da diese Dauermagnete 8,9,10 lediglich die Aufgabe haben, das Plasma 41,42 im vorderen Bereich der Zerstäubungskatode 6 zu konzentrieren. Die Plasmenbildung an zwei verschiedenen Stellen der Katodenkammer ergibt sich dadurch, daß zwischen der Anodenvorrichtung 19 und der Katodenvorrichtung 5 ein elektrisches Feld aufgrund der von den Spannungsquellen 18,20 kommenden Potentialen ansteht und in dieses Feld eine Blende 25 eingesetzt ist.

Die Blende 25 zwischen der Anodenvorrichtung 19 und der Katodenvorrichtung 5 beeinflußt zwar das elektrische Feld, doch sind die Potentiale der Spannungsquellen 18,20 so ausgelegt, daß die tatsächlich existierende Feldstärke vor der Zerstäubungskatode 6 ausreicht, um die Glimmentladung herbeizuführen, welche ihrerseits die Ursache für das Herausschlagen von Atomen aus der Zerstäubungskatode 6 ist. Die Blende 25 hat also, elektrisch gesehen, eine ähnliche Funktion wie das Steuergitter einer Elektronenröhre. Im Unterschied zu einem solchen Steuergitter ist die Blende 25 jedoch in ihren äußeren Bereichen eine absolute Sperre für die gasförmigen Atome und Moleküle, während sie in ihrem zentralen Bereich 26 die Atome und Moleküle ungehindert durchläßt.

Die Blende 25 liegt auf Masse und ist damit gegenüber der Anodenvorrichtung 19 negativ vorgespannt. Über die Stromquelle 20 an der Anodenvorrichtung 19 kann die Strömstärke, die über diese Anodenvorrichtung 19 fließt - und damit der Grad der Ionisation des Gases im Raum 71 - eingestellt werden. Dabei macht man sich die Tatsache zunutze, daß in der Umgebung des Katodenplasmas viele freie Ladungsträger existieren, insbesondere negativ geladene Elektronen, die infolge des positiven Potentials an der Anodenvorrichtung 19 durch die Blendenöffnung 26 zur Blende 22 hin beschleunigt werden. Die in diesen Raum eingelassenen Gasteilchen werden durch die Zusammenstöße mit den Elektronen ionisiert. Die Anodenvorrichtung 19 wird so angeordnet, daß sie durch die Blende 25 elektrisch abgeschirmt wird, so daß ohne Anliegen eines positiven Potentials nur ein geringfügiger Strom über die Anodenvorrichtung 19 fließt, der nur einige Prozent des Katodenstroms beträgt. Dies stellt sicher, daß für die Elektronen eine genügend große Beschleunigungsstrecke zur Verfügung steht, um ein vom Katodenplasma 41,42 getrenntes Plasma 43,44 und über Stoßionisation zusätzliche Ladungsträger zu erzeugen. Ohne bzw. mit einem geringen positiven Potential an der Anodenvorrichtung 19 werden die durch das Katodenplasma erzeugte Elektronen über die auf Masse liegende Blende 25 zur Spannungsquelle 20 zurückgeführt. Es ist in diesem Fall auch kein leuchtendes Plasma im Raum 71 vor dem Substrat zu beobachten. Für den Betriebsfall wird ein Strom über die Anodenvorrichtung 19 eingestellt, der zwischen 50 % und 100 % des durch die Katode fließenden Stroms beträgt. Die dazu notwendigen Potentiale an der Anodenvorrichtung 19 bewegen sich von ca. + 30 Volt bis zu + 100 Volt.

Wie bereits erwähnt, wird durch die Glimmentladung in dem Raum unmittelbar vor der zu beschichtenden Folie 4 das einströmende Ar, $O_2$-Gasgemisch ionisiert. Der ionisierte Sauerstoff geht hierbei eine chemische Verbindung mit dem von der Zerstäubungskatode 6 kommenden Aluminium eine Verbindung ein und schlägt sich als $Al_2 O_3$ auf der dünnen Folie 4 nieder. Der in dem Argon-Sauerstoff-Gemisch enthaltene Sauerstoff wird auf diese Weise schon weitgehend dem Gemisch entzogen, bevor dieses durch die Öffnung 26 auf der Zerstäubungselektrode 6 auftritt.

Um zu verhindern, daß sich derjenige Sauerstoff, der noch keine chemische Verbindung mit dem Aluminium eingegangen ist, auf der Zerstäubungskatode niederläßt und dort ein Oxid bildet, das den Zerstäubungsprozeß verschlechtert, wird das Gas über der Zerstäubungselektrode 6 fortlaufend durch die Pumpen 16,17 abgepumpt.

Jede der beschriebenen Einzelmaßnahmen - Einführung des Gasgemischs in einen vorgeschalteten, zusätzlichen Glimmraum bzw. Absaugen des Gases vor der Zerstäubungskatode 6 - bringt, je für sich genommen, einen erheblichen technischen Fortschritt mit sich. Umso größer ist dieser Fortschritt, wenn beide Maßnahmen zusammen zur Anwendung kommen.

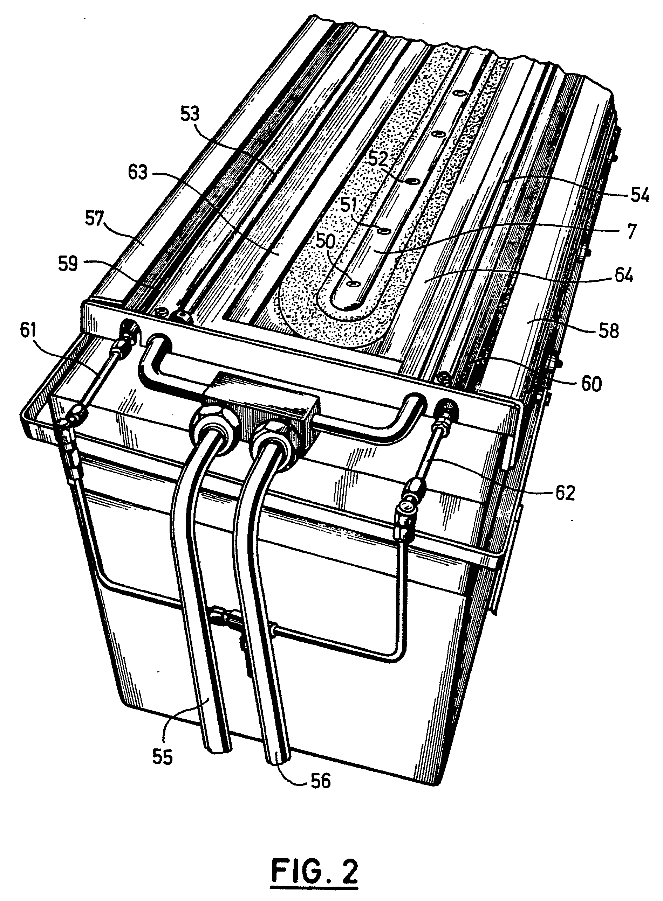

In der Fig. 2 ist eine technische Realisierung der in der Fig. 1 im Prinzip dargestellten Vorrichtung gezeigt. Man erkennt hierbei die Halterung 7 für die Zerstäubungskatode 6, die selbst nicht dargestellt ist. Diese Zerstäubungskatode 6 kann mittels Schrauben in den Gewindebohrungen 50,51,52 befestigt werden. Neben der Halterung 7 verlaufen Kühlrohre 53,54, die eine Fortsetzung der Kühlrohre 55,56 darstellen. Der Raum für die zusätzliche Glimmentladung wird durch die Stege 57 bzw. 58 und 59 bw. 60 gebildet. In diesen Raum strömt über die Gasleitungsrohre 61,62 Gas ein. Die Blende, welche die beiden Glimmentladungsräume gegeneinander abtrennt, ist durch die Bezugszahlen 63,64 gekennzeichnet. Die Schlitze, durch welche abgepumpt wird, sind in der Fig. 2 nicht zu erkennen. Sie befinden sich jeodch an den Seitenflächen, also z. B. unterhalb der Bezugszahl 58. Die ganze in der Fig. 2 dargestellte Vorrichtung befindet sich - ggf. mit mehreren gleichartigen Vorrichtungen - in einer Vakuumkammer, die von Pumpen abgesaugt wird. Das Absaugen der Vorrichtung erfolgt somit durch die nicht sichtbaren Schlitze, z. B. unterhalb der Bezugszahl 58, und durch Pumpen, die an dem Gehäuse angebracht sind, das die in der Fig. 2 dargestellte Vorrichtung umgibt. Sind mehrere Vorrichtungen der in der Fig. 2 gezeigten Art in dem erwähnten Gehäuse, das leergepumpt wird, vorgesehen, so kann zwischen diesen oder zwischen Gruppen solcher Vorrichtungen jeweils mindestens ein Abdichtblech vorgesehen sein. Solche Abdichtbleche würden etwa parallel zu den nach hinten sich erstreckenden Seitenflächen der in der Fig. 2 gezeigten Vorrichtung verlaufen und damit senkrecht auf der Oberfläche der Walze 3 stehen, die man sich oberhalb der Katodenhalterung vorstellen muß.

**Patentansprüche**

1. Vorrichtung (1) zum Aufbringen dünner Schichten auf ein Substrat durch das Kathodenzerstäubungsverfahren mit:
   - einer mechanischer Blende (25) die eine Öffnung (26) aufweist und zwischen einer zu zerstäubenden Kathode (6) und einer Anode (19) angeordnet ist, so daß ein erster Glimmentladungsraum (40) zwischen dieser Blende (25) und der Kathode (6) sowie ein zweiter Glimmentladungsraum (71) zwischen dieser Blende (25) und der Anode (19) entstehen;
   - einem Substrat (4), das unter der mit einer Öffnung versehenen Anode (19) angeordnet ist

- einer Gasverteilungsvorrichtung (31,32; 33,34; 35,36; 27,28) für den Einlaß eines nichtreaktiven Gases oder eines reaktiven Gasgemisches und
- einer Pumpvorrichtung (16,17) wobei die Anode (19) als zweite Blende unmittelbar über dem Substrat (4) angeordnet ist,
- der Gaseinlaß ausschließlich in dem zweiten Glimmentladungsraum (71) erfolgt,
- die Pumpvorrichtung (16,17) an den ersten Glimmentladungsraum (40) angeschlossen ist und ein Absaugen des Gases bzw. Gasgemisches vor der Kathode (6) bewirkt.

2. Vorrichtung nach Anspruch 1, **dadurch gekennzeichnet**, daß die zu zerstäubende Kathode (6) auf einem Potential von -400 V und die Anode (19) auf einem Potential von +30 bis +100V liegt.

3. Vorrichtung nach Anspruch 1, **dadurch gekennzeichnet**, daß die als zweite Blende (22) vorgesehene Anode (19) mit dem Substrat (4) enge Spalten bildet, deren Öffnungsquerschnitt maximal 20 % des Querschnitts der Öffnungen zu den Pumpen betragen, so daß durch diese Spalten nur geringe Mengen des eingelassenen Gasgemisches entweichen können.

4. Vorrichtung nach Anspruch 1, **dadurch gekennzeichnet**, daß sich die Vorrichtung (1) zusammen mit dem zu beschichtenden Substrat (4) innerhalb eines Gehäuses befindet, an dem Pumpen vorgesehen sind, welche über Spalten, die sich im Gehäuse (15,24) der Vorrichtung (1) befinden, Gase abpumpen.

5. Vorrichtung nach Anspruch 1, **dadurch gekennzeichnet**, daß insgesamt n Vorrichtungen (1) um eine Trommel (3) herum angeordnet sind, daß diese n Vorrichtungen durch Trennblöcke in m Gruppen unterteilt sind, wobei jeder Gruppe eine eigene Pumpvorrichtung zugeordnet ist.

6. Vorrichtung nach Anspruch 5, **dadurch gekennzeichnet**, daß die Pumpvorrichtung aus mindestens zwei Pumpen besteht, die an verschiedenen Stellen entlang der Längsachse einer Vorrichtung angeordnet sind.

7. Vorichtung nach Anspruch 5, **dadurch gekennzeichnet**, daß die Trommel (3) Teil einer mehrteiligen Transportvorrichtung ist.

8. Vorrichtung nach Anspruch 1, **dadurch gekennzeichnet**, daß der negative Pol einer Gleichspannungsquelle (18), der auf einem Potential von -500 V liegt, mit der Zerstäubungskathode (6) und der positive Pol dieser Gleichspannungsquelle (18) mit der Wand des metallischen Behälters (24), insbesondere mit der Blende (25) verbunden ist, daß ferner der positive Pol einer zweiten, regelbaren Gleichspannungsquelle (20), der auf einem Potential von +25 Volt bis +100 Volt liegt, mit einer zugeordneten Anodenvorrichtung (19) und der negative Pol dieser zweiten Gleichspannungsquelle (20) ebenfalls mit der Blende (25) verbunden ist.

**Claims**

1. Apparatus (1) for depositing thin layers on a substrate by the cathodic sputtering process with:
   - a mechanical shield (25) having an opening (26) and arranged between a cathode (6) to be sputtered and an anode (19) so that a first glow discharge space (40) is formed between this shield (25) and the cathode (6) and a second glow discharge space (71) is formed between this shield (25) and the anode (19);
   - a substrate (4) arranged below the anode (19) provided with an opening
   - a gas distributing device (31, 32; 33, 34; 35, 36; 27,28) for the introduction of a non-reactive gas or a reactive gas mixture and
   - a pumping means (16, 17)
   - the anode (19) being arranged as a second shield directly over the substrate (4),
   - the introduction of gas taking place exclusively in the second glow discharge space (71),
   - the pumping means (16, 17) being connected to the first glow discharge space (40) and causing extraction of the gas or gas mixture in front of the cathode (6).

2. Apparatus according to claim 1 characterised in that the cathode (6) to be sputtered is connected to a potential of -400 V and the anode (19) to a potential of +30 to +100 V.

3. Apparatus according to Claim 1 characterised in that the anode (19) forming a second shield (22) defines with the substrate (4) narrow gaps of which the open cross-section amounts at most to 20% of the cross-section of the openings leading to the pumps, so that only minimal quantities of the introduced gas mixture can escape through these gaps.

4. Apparatus according to Claim 1 characterised in that the apparatus (1) is present together with the substrate (4) which is to be coated in a housing on which are provided the pumps which, through gaps, pump away the gases present in the housing (15, 24) of the apparatus (1).

5. Apparatus according to Claim 1 characterised in that altogether n apparatuses (1) are arranged around a drum (3), that these n apparatuses are divided into m groups by separating blocks, each group having its own associated pumping means.

6. Apparatus according to claim 5 characterised in that the pumping means comprises at least two pumps which are arranged at different points along the longitudinal axis of an apparatus.

7. Apparatus according to claim 5 characterised in that the drum (3) is part of a multi-component transport device.

8. Apparatus according to Claim 1 characterised in that the negative pole of a direct current source (18), connected to a potential of -500 V, is connected to the sputtering cathode (6) and the positive pole of this direct current source (18) is connected to the wall of the metallic container (24), in particular to the shield (25), that furthermore the positive pole of a second, adjustable, direct current source (20), which is connected to a potential of +25 volts to +100 volts, is connected to an associated anode device (19) and the negative pole of this second direct current source (20) is likewise connected to the shield (25).

**Revendications**

1. Dispositif (1) pour le dépôt de couches minces sur un substrat, suivant le procédé de vaporisation de cathode, avec :
   - un masque mécanique (25) qui présente une ouverture (26) et est disposé entre une cathode à vaporiser (6) et une anode (19), de telle façon qu'un premier espace de décharge électrique (40) soit constitué entre ce masque (25) et la cathode (6), ainsi qu'un deuxième espace de décharge électrique (71), entre ce masque (25) et l'anode (19);
   - un substrat (4), disposé au-dessous de l'anode (19) pourvue d'une ouverture,
   - un dispositif de distribution de gaz (31,32;33,34;35,36;27,28) pour l'admission d'un gaz non réactif ou d'un mélange de gaz réactif, et
   - un dispositif de pompage (16,17) où l'anode (19) est dispose à titre de deuxième masque, directement au-dessus du substrat (4),
   - l'admission de gaz s'effectue exclusivement dans le deuxième espace de décharge électrique (71),
   - le dispositif de pompage (16,17) est raccordé au premier espace de décharge électrique (40) et provoque une aspiration du gaz, respectivement du mélange de gaz, devant la cathode (6).

2. Dispositif selon la revendication 1, caractérisé en ce que la cathode à vaporiser (6) est placée à un potentiel de -400 V et l'anode (19) à un potentiel allant de +30 à +100 V.

3. Dispositif selon la revendication 1, caractérisé en ce que l'anode (19), prévue à titre de deuxième masque (22), forme avec le substrat (4) des interstices étroits, dont la section transversale d'ouverture est au maximum de 20% de la section transversale des ouvertures allant aux pompes, de sorte que ne peuvent s'échapper par ces interstices que de faibles quantités du mélange de gaz introduit.

4. Dispositif selon la revendication 1, caractérisé en ce que le dispositif (1), conjointement avec le substrat (4) à recouvrir, se trouve dans un carter sur lequel sont prévues des pompes, qui pompent les gaz par les interstices qui se trouvent dans le carter (15,24) du dispositif (1).

5. Dispositif selon la revendication 1, caractérisé en ce qu'est prévu un total de n dispositifs (1) autour d'un tambour (3), que ces n dispositifs sont subdivisés en m groupes par des blocs de séparation, un dispositif de pompage étant associé à chaque groupe.

6. Dispositif selon la revendication 5, caractérisé en ce que le dispositif de pompage se compose d'au moins deux pompes, disposées en des emplacements différents, le long de l'axe longitudinal d'un dispositif.

7. Dispositif selon la revendication 5, caractérisé en ce que le tambour (3) fait partie d'un dispositif de transport en plusieurs parties.

8. Dispositif selon la revendication 1, caractérisé en ce que le pôle négatif d'une source de tension continue (18), qui est placé à un potentiel de -500 V, est relié à la cathode de vaporisation (6) et le pôle positif de cette source de tension continue (18) est relié à la paroi du récipient métallique (24), en particulier relié au masque (25), qu'en outre le pôle positif d'une deuxième source de tension continue (20) réglable, placé à une tension allant de +25 Volt à +100 Volt, est relié à un dispositif d'anode (19) associé et le pôle négatif de cette deuxième source de tension continue (20) est également relié au masque (25).

**FIG.1**

## FIG. 2